# EUROPÄISCHE PATENTSCHRIFT

(11) **EP 3 172 826 B1**
(45) Veröffentlichungstag und Bekanntmachung des Hinweises auf die Patenterteilung: **17.04.2019**
(21) Anmeldenummer: 15757120.9
(22) Anmeldetag: 21.07.2015
(51) Int. Cl.: H02N 2/00, H01L 41/083

(54) **ULTRASCHALLMOTOR**
ULTRASONIC MOTOR
MOTEUR ULTRASONIQUE

(30) Priorität: 23.07.2014 DE 102014214357
(43) Veröffentlichungstag der Anmeldung: 31.05.2017
(73) Patentinhaber: Physik Instrumente (PI) GmbH & Co. KG, 76228 Karlsruhe (DE)
(72) Erfinder: WISCHNEWSKIY, Wladimir, 14712 Rathenow (DE); WISCHNEWSKI, Alexej, 76744 Wörth (DE)
(74) Vertreter: Grünecker Patent- und Rechtsanwälte PartG mbB
(86) Internationale Anmeldenummer: PCT/DE2015/200409
(87) Internationale Veröffentlichungsnummer: WO 2016/012020

(56) Entgegenhaltungen:
- DE-A1- 19 938 954
- US-A1- 2006 238 072
- US-A1- 2008 122 316

## Beschreibung

Die Erfindung betrifft einen Ultraschallmotor gemäß dem Oberbegriff des unabhängigen Patentanspruchs 1. Ein derartiger Ultraschallmotor ist aus der DE 199 38 954 A1 bekannt.

Aus der US 6,806,620 B1 ist ein Ultraschallmotor bekannt, bei welchem im Aktor die akustischen Biege- und Längsstehwellen mit Hilfe von zwei voneinander getrennten und unabhängigen Generatoren für diese Wellen erzeugt werden.

Weiterhin sind beispielsweise aus der US 5,877,579 und der US 5,714,833 Ultraschallmotoren bekannt, bei denen in den Aktoren die akustischen Biege- und Längsstehwellenwellen mit ein- und demselben Generator erzeugt werden.

Bei diesen aus dem Stand der Technik bekannten Motoren wird in den Aktoren die akustische Biegestehwelle dadurch erzeugt, dass die piezoelektrische Platte über ihre Höhe bzw. Breite gebogen wird. Für das Biegen der piezoelektrischen Platte des Aktors über ihre Höhe ist eine entsprechend hohe elektrische Spannung erforderlich. Bei einer solchen Erregung der piezoelektrischen Platte treten in ihr hohe mechanische Verluste auf. Das verringert sowohl die maximale Bewegungsgeschwindigkeit des anzutreibenden Elements als auch die maximale vom Motor entwickelte Kraft und erhöht gleichzeitig die Verluste im Aktor des Motors. All das zusammen verringert die Leistungsfähigkeit und den Wirkungsgrad dieser Motoren.

Aufgabe der Erfindung ist es daher, einen Ultraschallmotor bereitzustellen, der die vorgenannten Nachteile der aus dem Stand der Technik bekannten Ultraschallmotoren überwindet, und dementsprechend einen Ultraschallmotor mit erhöhter maximaler Bewegungsgeschwindigkeit und Kraft bei verringerten mechanischen Verlusten bereitstellt.

Diese Aufgabe wird gelöst durch einen Ultraschallmotor nach Anspruch 1, wobei die sich daran anschließenden Unteransprüche mindestens zweckmäßige Ausgestaltungen und Weiterbildungen umfassen.

Demnach wird von einem Ultraschallmotor ausgegangen, welcher einen als Wellenleiter-Resonator fungierenden Ultraschallaktor in Form einer rechteckigen piezoelektrischen Platte mit zwei flächenmäßig größten Hauptflächen und die Hauptflächen miteinander verbindenden Seitenflächen, ein anzutreibendes Element und eine elektrische Erregervorrichtung umfasst. Hierbei sind die Hauptflächen vorzugsweise parallel zueinander angeordnet, und es sind vorzugsweise vier Seitenflächen vorhanden, wovon zwei Seitenflächen kürzer als die übrigen beiden Seitenflächen sind.

An wenigstens einer Seitenfläche des Ultraschallaktors ist mindestens ein Friktionselement angeordnet ist, welches mit dem anzutreibenden Element in Wirk- oder Friktionskontakt steht.

Die piezoelektrische Platte ist entlang ihrer Längsrichtung, als in die Richtung der größten Ausdehnung der piezoelektrischen Platte, in drei Teile unterteilt, wobei der zentrale oder mittlere Teil einen Generator für eine akustische Längsstehwelle bildet und die an den zentralen Teil angrenzenden peripheren Teile Generatoren für eine akustische Biegestehwelle bilden. Alle Generatoren sind hierbei mit der elektrischen Erregervorrichtung verbunden.

Jeder der Generatoren für eine akustische Biegestehwelle ist entlang der Dickenrichtung der piezoelektrischen Platte, d.h. in Richtung der geringsten Ausdehnung der piezoelektrischen Platte, in zwei gleichgroße Teilgeneratoren unterteilt, wobei jeder der Teilgeneratoren einzeln oder separat elektrisch ansteuerbar ist und Schichten von Erregerelektroden, Schichten von allgemeinen Elektroden und dazwischen angeordneten Schichten von Piezokeramik aufweist.

Es kann vorteilhaft sein, dass der Generator für die akustische Längsstehwelle Schichten von Erregerelektroden, Schichten von allgemeinen Elektroden und dazwischen angeordneten Schichten von Piezokeramik umfasst.

Es kann ebenso vorteilhaft sein, dass der Generator für die akustische Längsstehstehwelle entlang der Dickenrichtung der piezoelektrischen Platte in zwei gleichgroße und elektrisch einzeln oder separat ansteuerbare Teilgeneratoren unterteilt ist, und jeder der Teilgeneratoren Schichten von Erregerelektroden, Schichten von allgemeinen Elektroden und dazwischen angeordneten Schichten von Piezokeramik aufweisen.

Weiterhin kann es vorteilhaft sein, dass die Schichten von Erregerelektroden und die Schichten allgemeiner Elektroden und die Schichten von jeweils dazwischen angeordneter Piezokeramik parallel zu den Hauptflächen angeordnet sind.

Zudem kann es vorteilhaft sein, dass das Verhältnis von Länge zu Dicke des Ultraschallaktors zwischen 9 und 11 liegt, so dass im Ultraschallaktor gleichzeitig die erste Mode der akustischen Deformationslängswelle und die dritte Mode der akustischen Deformationsbiegewelle gleicher Frequenz anregbar ist.

Ferner kann es vorteilhaft sein, dass das Verhältnis von Breite zu Dicke des Ultraschallaktors zwischen 2 und 3 liegt.

Außerdem kann es vorteilhaft sein, dass die in Dickenrichtung gesehen benachbarten Piezokeramikschichten entgegengesetzt gerichtet, d.h. antiparallel, polarisiert sind.

Darüber hinaus kann es vorteilhaft sein, dass die elektrische Erregervorrichtung eine elektrische Zweiphasenspannung gleicher Frequenz zur unabhängigen symmetrischen Zweiphasenerregung des Generators für die akustische Längsstehwelle und der Generatoren für die akustische Biegestehwelle bereitstellt.

Es kann ebenso von Vorteil sein, dass die elektrische Erregervorrichtung eine elektrische Einphasenspannung zur gleichzeitigen symmetrischen Erregung des Generators für die akustische Längsstehwelle und zur asymmetrischen Erregung der Generatoren für die akustische Biegestehwelle bereitgestellt.

Schließlich kann es von Vorteil sein, dass die elektrische Erregervorrichtung eine elektrische Einphasenspannung zur gleichzeitigen asymmetrischen Erregung des Generators für die akustische Längsstehwelle und zu asymmetrischen Erregung der Generatoren für die akustische Biegestehwelle bereitstellt.

Es zeigen in schematischer und nicht maßstäblicher Weise:
Fig. 1: Eine Ausführungsform des erfindungsgemäßen Ultraschallmotors
Fig. 2: Eine weitere Ausführungsform des erfindungsgemäßen Ultraschallmotors
Fig. 3: Darstellungen 15 bis 18: Unterschiedliche Ausführungsformen des Aktors eines erfindungsgemäßen Ultraschallmotors
Fig. 4: Eine Ausführungsform des Aktors eines erfindungsgemäßen Ultraschallmotors
Fig. 5: Eine weitere Ausführungsform des Aktors eines erfindungsgemäßen Ultraschallmotors
Fig. 6: Darstellung einer Möglichkeit zur elektrischen Verbindung der Elektroden der Generatoren des Aktors eines erfindungsgemäßen Ultraschallmotors bei Verwendung einer Zweiphasenerregervorrichtung
Fig. 7: Darstellung einer weiteren Möglichkeit zur elektrischen Verbindung der Elektroden der Generatoren des Aktors eines erfindungsgemäßen Ultraschallmotors bei Verwendung einer Zweiphasenerregervorrichtung
Fig. 8: Darstellung einer Möglichkeit zur elektrischen Verbindung der Elektroden der Generatoren des Aktors eines erfindungsgemäßen Ultraschallmotors bei Verwendung einer Einphasenerregervorrichtung
Fig. 9: Darstellung einer weiteren Möglichkeit zur elektrischen Verbindung der Elektroden der Generatoren des Aktors eines erfindungsgemäßen Ultraschallmotors bei Verwendung einer Einphasenerregervorrichtung
Fig. 10: Darstellungen 35 und 36: elektrisch angeregte Regionen des Ultraschallaktors eines erfindungsgemäßen Ultraschallmotors bei einer Schaltung gemäß Fig. 6 und Fig. 7; Darstellungen 37 und 38: elektrisch angeregte Regionen des Ultraschallaktors eines erfindungsgemäßen Ultraschallmotors bei einer Schaltung gemäß Fig. 8; Darstellungen 39 und 40: elektrisch angeregte Regionen des Ultraschallaktors eines erfindungsgemäßen Ultraschallmotors bei einer Schaltung gemäß Fig. 9
Fig. 11: Darstellungen 41 und 42: Phasen der maximalen Deformation der in dem Aktor eines erfindungsgemäßen Ultraschallmotors erzeugten Längsstehwelle

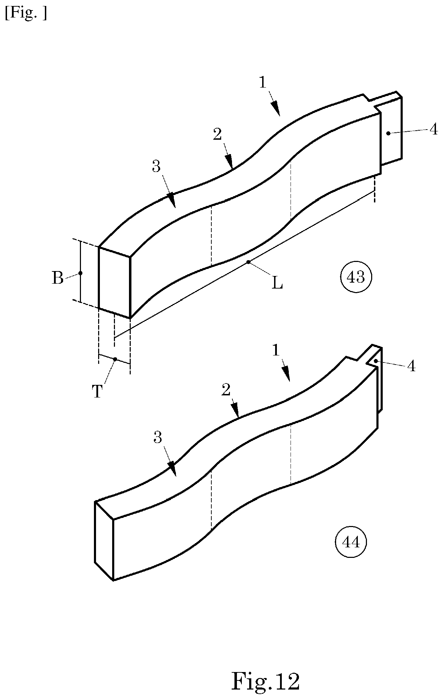

Fig. 12: Darstellungen 43 und 44: Phasen der maximalen Deformation der in dem Aktor eines erfindungsgemäßen Ultraschallmotors erzeugten Biegestehwelle

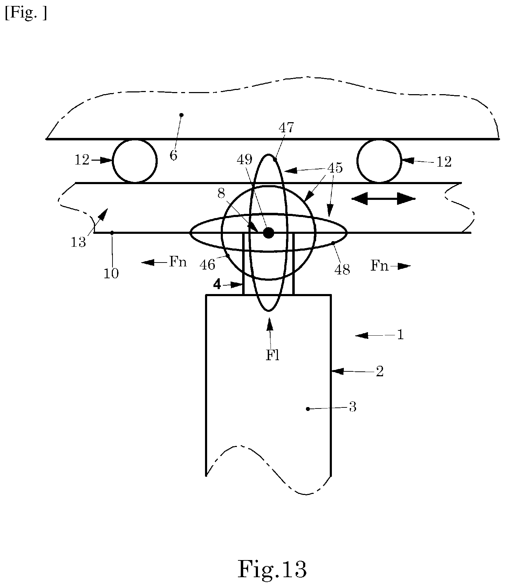

Fig. 13: Darstellung möglicher Bewegungsbahnen eines Punktes auf dem Friktionselement eines Aktors eines erfindungsgemäßen Ultraschallmotors bei einer Zweiphasenerregung
Fig. 14: Darstellung möglicher Bewegungsbahnen eines Punktes auf dem Friktionselement eines Aktors eines erfindungsgemäßen Ultraschallmotors bei einer Einphasenerregung
Fig. 15: Mögliche Ausführungsform des erfindungsgemäßen Ultraschallmotors als Antrieb einer Linse in einem Mikroobjektiv

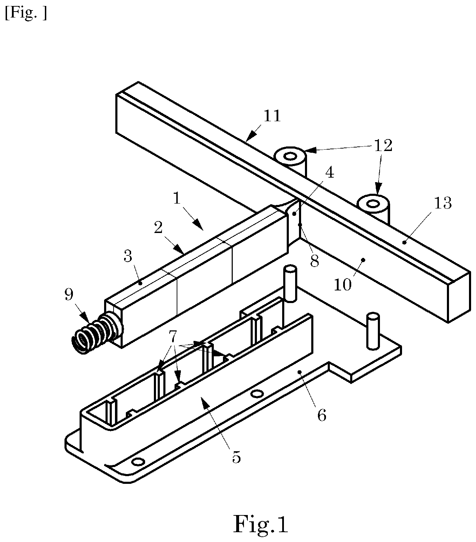

Gemäß Fig. 1 umfasst die dort gezeigte mögliche Ausführungsform eines erfindungsgemäßen Linear-Ultraschallmotors einen rechteckförmigen Ultraschallaktor 1, der gleichzeitig als Wellenleiter-Resonator 2 für eine akustische Stehwelle fungiert, in Form einer piezoelektrische Platte 3 mit einem an einer seinen Stirnflächen angeordneten Friktionselement 4. Der Ultraschallaktor weist hierbei zwei gegenüberliegend angeordnete und parallel zueinander verlaufende Stirnflächen auf, wobei die Stirnflächen durch die flächenmäßig kleinsten Seitenflächen des Ultraschallaktors gebildet sind. Das Friktionselement befindet sich in mechanischem (Friktions-)Kontakt mit einer Friktionsschicht 10, welche an einem anzutreibenden Element 11 in Form eines Stabes 13 derart angeordnet ist, dass sie die entsprechende Seitenfläche des anzutreibenden Elements vollständig bedeckt. Die Querschnittsfläche des Friktionselements verjüngt sich ausgehend von der Kontaktfläche zwischen der piezoelektrischen Platte und dem Friktionselement in Richtung der Friktionsschicht. Das anzutreibende Element ist linear beweglich über zwei Kugellager 12 gelagert.

Der Ultraschallaktor 1 ist in der Halterung 5 des Gehäuses 6 so angeordnet, dass er längs der Führungsschienen 7 verschoben werden kann. Das Friktionselement 4 ist mit seiner Friktionsoberfläche 8 mit Hilfe der Feder 9 an die Friktionsschicht 10 des anzutreibenden Elements 11 angepresst.

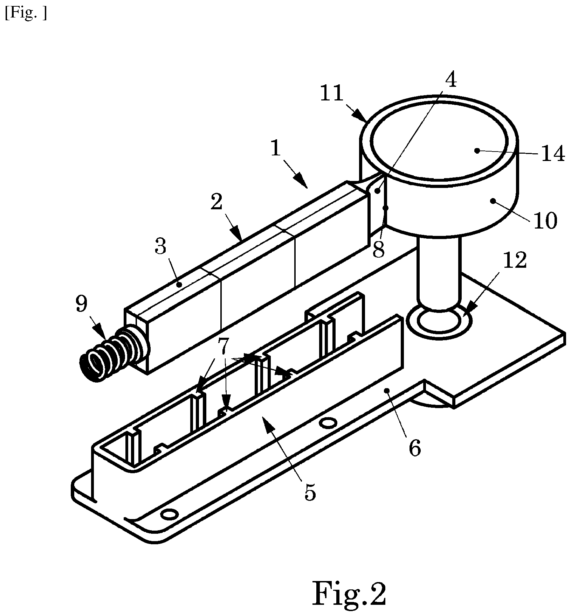

Fig. 2 zeigt eine Ausführungsform eines erfindungsgemäßen Rotations-Ultraschallmotors, der sich geringfügig vom Aufbau des linearen Ultraschallmotors gemäß Fig. 1 unterscheidet, weshalb im Folgenden nur auf die entsprechenden Unterschiede eingegangen wird.

Das anzutreibende Element 11 besitzt hier die Form einer runden Scheibe und stellt einen Rotor 14 dar, auf dessen äußeren Umfangsfläche die Friktionsschicht 10 angeordnet ist. Ein an dem Rotor angeordneter und mit diesem verbundener Schaft ist durch das Kugellager 12 drehbar gelagert.

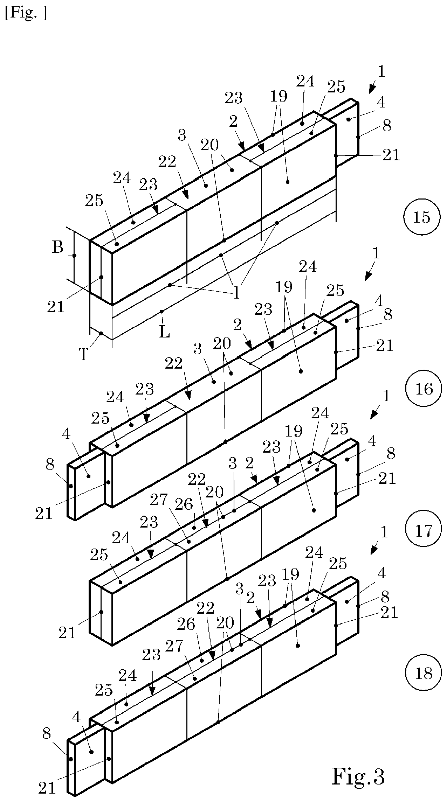

Die Darstellungen 15 bis 18 von Fig. 3 zeigen unterschiedliche Ausführungsvarianten für einen Ultraschallaktor 1 des erfindungsgemäßen Ultraschallmotors. Jeder der dort gezeigten Ultraschallaktoren umfasst zwei flächenmäßig größte Hauptflächen 19, zwei lange Seitenflächen 20 und zwei kurze Seitenflächen, welche Stirnflächen 21 bilden. Weiterhin weist jeder der in den Darstellungen 15 bis 18 gezeigten Ultraschallaktoren eine Länge L, eine Breite B und eine Dicke T auf.

Jeder der in den Darstellungen 15 bis 18 gezeigten Ultraschallaktoren ist entlang seiner Länge in drei Teile der Länge 1 unterteilt, wobei der zentrale Teil einen Generator 22 für eine akustische Längsstehwelle bildet und die an den zentralen Teil angrenzenden peripheren Teile Generatoren 23 für eine akustische Biegestehwelle bilden.

Bei den Ultraschallaktoren gemäß den Darstellungen 15 und 16 sind die Generatoren 23 für eine akustische Biegestehwelle entlang der Dickenrichtung der piezoelektrischen Platte bzw. des Ultraschallaktors in zwei gleichgroße und elektrisch einzeln ansteuerbare Teilgeneratoren 24 und 25 unterteilt, wobei die Teilgeneratoren Schichten von Erregerelektroden, Schichten von allgemeinen Elektroden und dazwischen angeordneten Schichten von Piezokeramik aufweisen, wobei die allgemeinen Elektroden und die Erregerelektroden jedes Teilgenerators mit der elektrischen Erregervorrichtung verbunden sind.

Bei den Ultraschallaktoren gemäß den Darstellungen 17 und 18 ist neben den Generatoren 23 für eine akustische Biegestehwelle auch der jeweilige Generator für eine akustische Längsstehwelle 22 entlang der Dickenrichtung der piezoelektrischen Platte bzw. des Ultraschallaktors in zwei gleichgroße und elektrisch einzeln ansteuerbare Generatorenteile 26 und 27 unterteilt, wobei jeder Generatorteil Schichten von Erregerelektroden, Schichten von allgemeinen Elektroden und dazwischen angeordneten Schichten von Piezokeramik aufweist, und die allgemeinen Elektroden und die Erregerelektroden jedes Generatorteils mit der elektrischen Erregervorrichtung verbunden sind.

Während bei den Ultraschallaktoren gemäß den Darstellungen 15 und 17 nur an einer der beiden Stirnflächen 21 ein Friktionselement 4 angeordnet ist, befinden sich bei den Ultraschallaktoren gemäß den Darstellungen 16 und 18 an beiden Stirnflächen 21 jeweils ein Friktionselement 4. In allen Fällen besitzt das Friktionselement 4 eine rechteckige Form mit einer Friktionsoberfläche 8 an seinem freien Ende.

In allgemeiner Weise wird für den Ultraschallaktor des erfindungsgemäßen Ultraschallmotor die Länge L der piezoelektrischen Platte 1 so gewählt, dass sie etwa gleich der halben Wellenlänge λₗ der sich längs zur Länge L im Wellenleiter-Resonator 2 mit der Frequenz fₐ sich ausbreitenden akustischen Längsdeformationswelle ist, so dass sich in der piezoelektrischen Platte 3 die erste Mode einer akustischen Längsstehwelle ausbildet.

Die Frequenz fₐ kann aus der Formel fₐ=N/L bestimmt werden, wobei N vom Typ der Piezokeramik abhängig ist. Für die Piezokeramik PIC 181 der Fa. PI Ceramic GmbH Keramische Technologien und Bauelemente, Lederhose (Thüringen), istN=1278Hzm.

Weiterhin ist die Dicke T der piezoelektrischen Platte 3 des Ultraschallaktors 1 so gewählt, dass sich in der piezoelektrischen Platte 3 bei der Länge L eine akustische Deformationsstehwelle mit der gleichen Frequenz fₐ ausbreitet, so dass sich in der piezoelektrischen Platte 3 die dritte Mode einer akustischen Biegestehwelle ausbildet.

Die Dicke T der piezoelektrischen Platte 3 kann näherungsweise aus der Formel T=L/kbestimmt werden, wobei k=L/T zwischen 9 und 11 liegt. Die Breite B der piezoelektrischen Platte 3 kann sich im Bereich von 2T bis 3T bewegen.

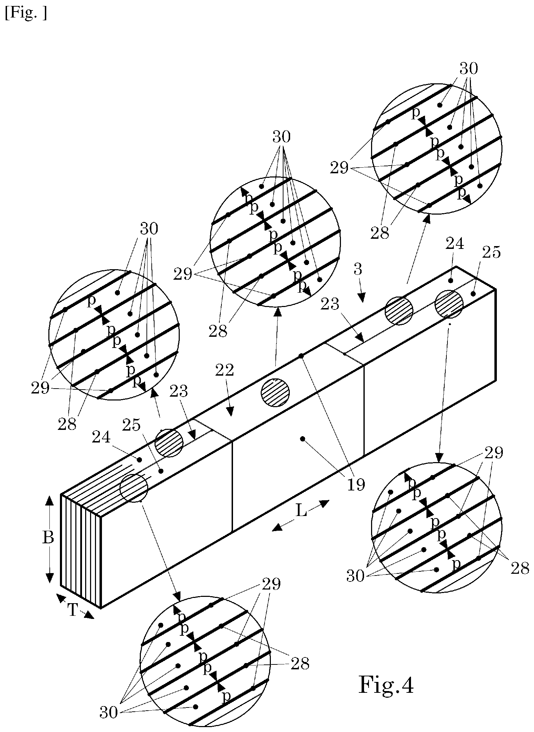

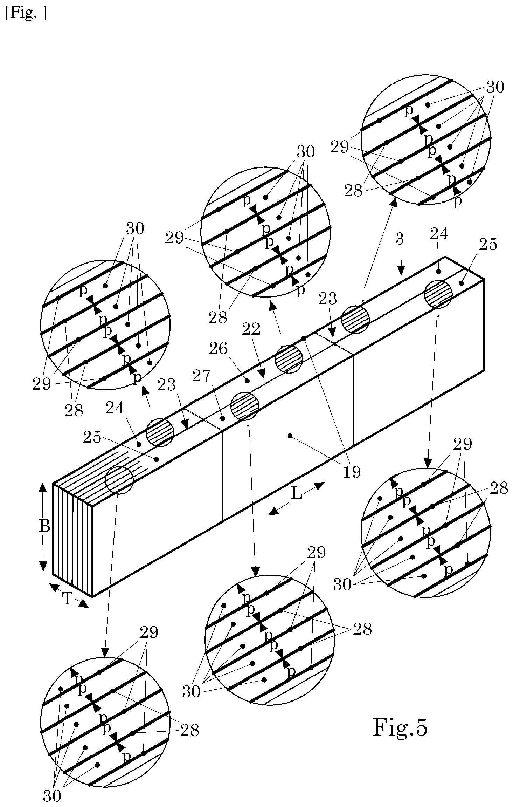

Fig. 4 zeigt einen möglichen inneren Aufbau der piezoelektrischen Platte 3 bzw. des Ultraschallaktors 1 gemäß den Darstellungen 15 und 16 von Fig. 3, während Fig. 5 einen möglichen inneren Aufbau der piezoelektrischen Platte 3 bzw. des Ultraschallaktors 1 gemäß den Darstellungen 17 und 18 von Fig. 3 zeigt. Die Generatoren 22 und 23 der piezoelektrischen Platte 3 umfassen Erregerelektroden 28, allgemeine Elektroden 29 und jeweils zwischen diesen angeordnete Schichten von Piezokeramik 30. Dabei sind sowohl die Erregerelektroden, als auch die allgemeinen Elektroden parallel zu den Hauptflächen des Ultraschallaktors bzw. der piezoelektrischen Platte angeordnet. Benachbarte Piezokeramikschichten 30 sind entgegengesetzt gerichtet polarisiert, wobei die Polarisationsrichtung jeweils senkrecht zu den Elektroden 28 und 29 ist. Die Polarisationsrichtung ist in Fig. 4 jeweils mit einem Pfeil mit dem Index p gekennzeichnet.

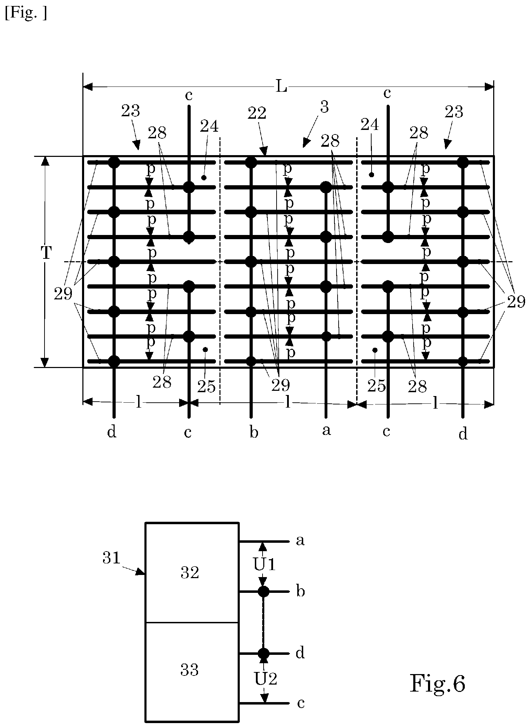

Fig. 6 zeigt eine Möglichkeit zur elektrischen Verbindung der Elektroden der Generatoren eines Ultraschallaktors eines erfindungsgemäßen Ultraschallmotors gemäß Fig. 5 bei Verwendung einer Zweiphasenerregervorrichtung zur symmetrischen Zweiphasenerregung der Generatoren 22 und 23. Die angrenzenden Piezokeramikschichten 30 der Generatorenteile 24 und 25 haben hierbei die gleiche Polarisationsrichtung. Es ist möglich, dass die Polarisationsrichtung der Piezokeramikschichten 30 in den Teilgeneratoren 24 - bezogen auf die Piezokeramikschichten 30 in den Teilgeneratoren 25 - unterschiedlich ist. Ebenso ist es möglich, dass die Polarisationsrichtung der Piezokeramikschichten 30 in den Teilgeneratoren 26 - bezogen auf die Piezokeramikschichten 30 in den Teilgeneratoren 25 - unterschiedlich ist.

Fig. 6 zeigt ferner ein Blockschaltbild betreffend die Verbindung der Elektroden 28 und 29 der Generatoren 22 und 23 der piezoelektrischen Platte 3 mit einer elektrischen Zweiphasenerregervorrichtung 31.

Die elektrische Zweiphasenerregervorrichtung 31 besteht hierbei aus den Generatoren für die elektrischen Spannungen 32 und 33. Diese Generatoren stellen die elektrischen Wechselspannungen U1 und U2 mit gleicher Frequenz fₐ bereit, die zueinander um den Winkel φ phasenverschoben sind.

Die Spannung U1 ist über die Anschlüsse a, b an die Elektroden 28, 29 der Generatoren 22 angelegt, während die Spannung U2 über die Anschlüsse d, c an die Elektroden 28, 29 der Generatoren 23 angelegt ist.

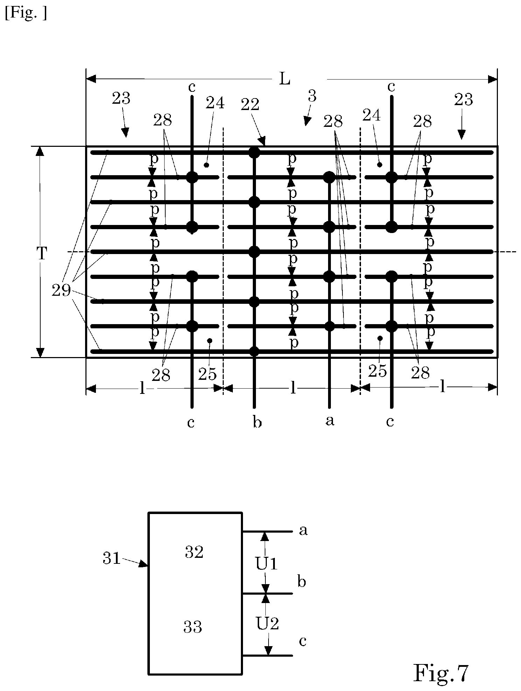

Fig. 7 zeigt eine weitere Möglichkeit zur elektrischen Verbindung der Elektroden der Generatoren eines Ultraschallaktors eines erfindungsgemäßen Ultraschallmotors gemäß Fig. 5 bei Verwendung einer Zweiphasenerregervorrichtung zur symmetrischen Zweiphasenerregung der Generatoren 22 und 23.

Fig. 7 zeigt ferner das Blockschaltbild betreffend die Verbindung der Elektroden 28 und 29 der Generatoren 22 und 23 mit der elektrischen Zweiphasenerregervorrichtung 31 der piezoelektrischen Platte 3. Die allgemeinen Elektroden 29 sind hier miteinander verbunden.

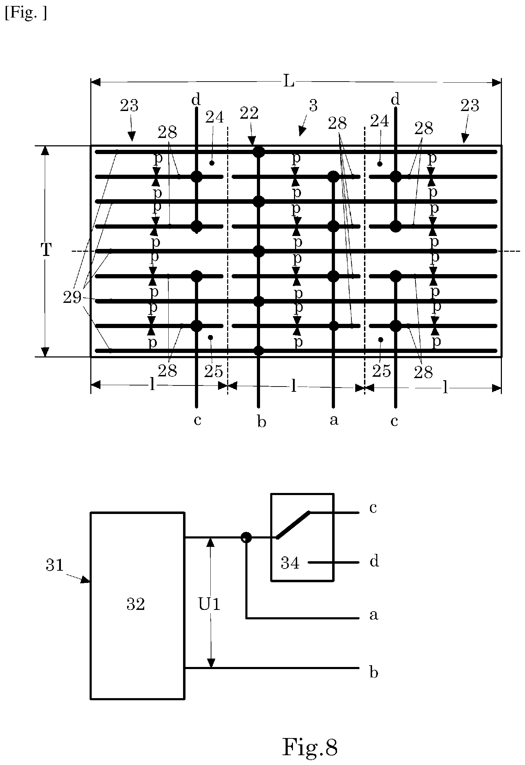

Fig. 8 zeigt eine Möglichkeit zur elektrischen Verbindung der Elektroden der Generatoren eines Ultraschallaktors eines erfindungsgemäßen Ultraschallmotors gemäß Fig. 5 bei Verwendung einer Einphasenerregervorrichtung. Ferner zeigt Fig. 8 das Blockschaltbild betreffend die Verbindung der Elektroden 28 und 29 der Generatoren 22 und 23 des Ultraschallaktors mit der elektrischen Erregervorrichtung 31.

Hierbei besteht die elektrische Erregervorrichtung 31 aus dem Generator 32, der die elektrische Wechselspannung U1 bereitstellt. Diese Spannung wird über die Anschlüsse a und b an die Elektroden 28 und 29 des Generators 22 und über den Umschalter 34 und die Anschlüsse c an die Elektroden 28 und 29 der Teilgeneratoren 24 der Generatoren 23 gelegt, oder es werden über den Umschalter 34 die Anschlüsse d mit den Elektroden 28 und 29 der Teilgeneratoren 25 der Generatoren 23 verbunden.

Die in Fig. 8 gezeigte elektrische Schaltung realisiert die symmetrische Erregung des Generators 22 und die asymmetrische Erregung der Generatoren 23.

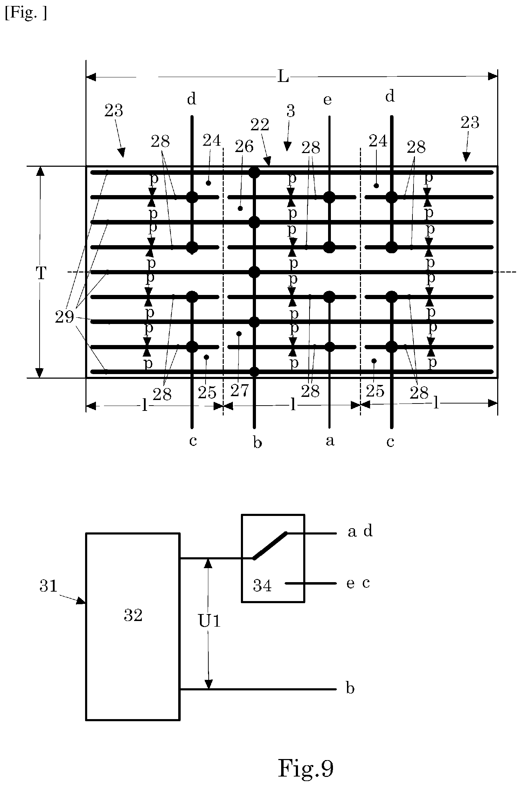

Fig. 9 zeigt eine weitere Möglichkeit zur elektrischen Verbindung der Elektroden der Generatoren eines Ultraschallaktors eines erfindungsgemäßen Ultraschallmotors gemäß Fig. 5 bei Verwendung einer Einphasenerregervorrichtung. Zudem zeigt Fig. 9 auch ein entsprechendes Blockschaltbild betreffend die die Verbindung der Elektroden 28 und 29 der Generatoren 22 und 23 des Ultraschallaktors mit der elektrischen Erregervorrichtung 31.

Dabei wird die Spannung U1 über den Umschalter 34 und die Anschlüsse a, d an die Elektroden 28 und 29 der Teilgeneratoren 24 der Generatoren 23 und an die Elektroden 28 und 29 des Teilgenerators 27 des Generators 22 gelegt. Möglich ist es auch, die Spannung U1 über den Umschalter 34 und die Anschlüsse e, c an die Elektroden 28 und 29 der Teilgeneratoren 25 der Generatoren 23 und an die Elektroden 28 und 29 des Teilgenerators 27 des Generators 22 zu legen.

Die in Fig. 9 gezeigte elektrische Schaltung ermöglicht die asymmetrische Erregung des Generators 22 und die asymmetrische Erregung der Generatoren 23.

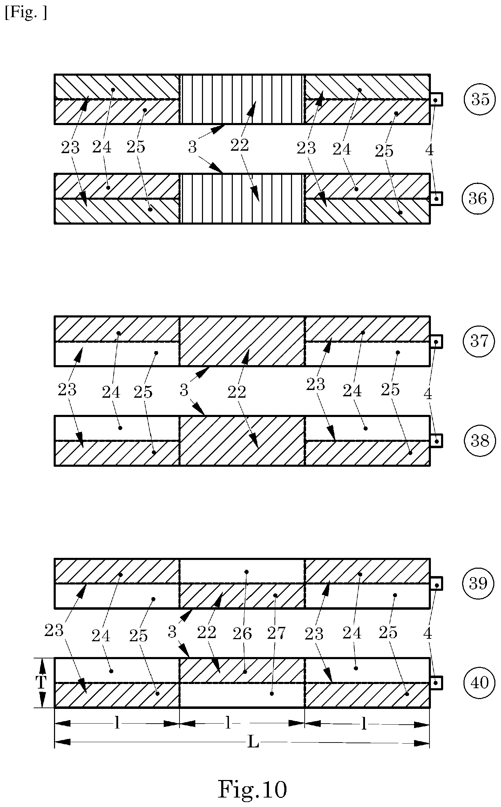

Die Darstellungen 35 und 36 von Fig. 10 verdeutlichen die elektrisch angeregten Regionen des Ultraschallaktors bzw. der Generatoren oder der Teilgeneratoren eines erfindungsgemäßen Ultraschallmotors bei Anwendung einer elektrischen Schaltung gemäß Fig. 6 und Fig. 7. Im Generator 22 liegt hierbei die Spannung U1 an, während in den Generatoren 23 die Spannung U2 anliegt. Da die Teilgeneratoren 24 und 25 bzw. das entsprechende piezoelektrische Material unterschiedliche Polarisationsrichtungen aufweisen bzw. aufweist, sind die Schraffuren dort unterschiedlich, obwohl das gleiche elektrische Potential in den unterschiedlichen Generatorteilen vorliegt.

Die Darstellungen 37 und 38 zeigen die elektrisch angeregten Regionen des Ultraschallaktors bzw. der Generatoren oder der Teilgeneratoren eines erfindungsgemäßen Ultraschallmotors bei einer Schaltung gemäß Fig. 8. Hier liegt sowohl am Generator 22, als auch an den entsprechenden Teilgeneratoren 24 und 25 der Generatoren 23 die Spannung U1 an.

Schließlich zeigen die Darstellungen 39 und 40 die elektrisch angeregten Regionen des Ultraschallaktors bzw. der Generatoren oder der Teilgeneratoren eines erfindungsgemäßen Ultraschallmotors bei einer Schaltung gemäß Fig. 9.

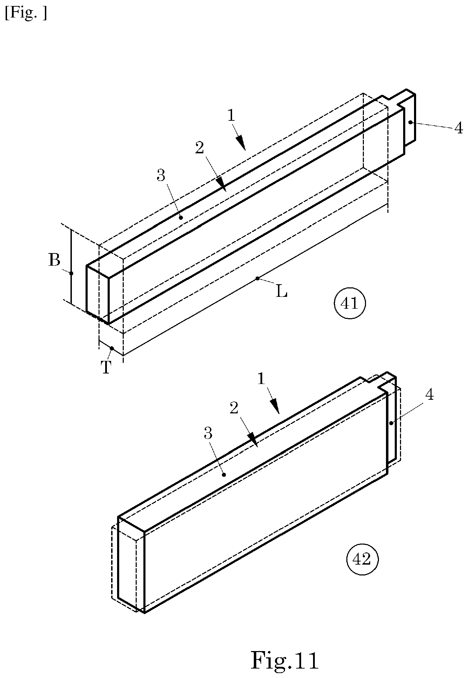

Die Darstellungen 41 und 42 von Fig. 11 zeigen die Phasen der maximalen Deformation der in dem Aktor eines erfindungsgemäßen Ultraschallmotors erzeugten Längsstehwelle, während die Darstellungen 43 und 44 die Phasen der maximalen Deformation der in dem Aktor eines erfindungsgemäßen Ultraschallmotors erzeugten Biegestehwelle zeigen.

Bei einer Zweiphasenerregung des Ultraschallaktors 1 durch die Spannungen U1 und U2 gemäß den Figuren 6 und 7 mit der Frequenz fₐ werden in der piezoelektrischen Platte 3 gleichzeitig die zwei oben beschriebenen Stehwellen erzeugt, d.h. eine Längsstehwelle und eine Biegestehwelle. Durch die Überlagerung dieser Wellen bewegt sich das Friktionselement 4 gemäß Fig. 11 auf einer geschlossenen Bewegungsbahn 45, welche für den auf der Friktionsoberfläche 8 des Friktionselements 4 liegenden Punkt 49 die Form eines Kreises 46 oder die Form einer Ellipse 47 bzw. 48 haben kann.

Die Form der Bewegungsbahn 45 und seine Neigung zur Friktionsschicht 10 des anzutreibenden Elements 11 wird durch das Verhältnis der Amplitude der Spannungen U1 und U2 und dem Wert des Phasenverschiebungswinkels zwischen diesen Spannungen bestimmt.

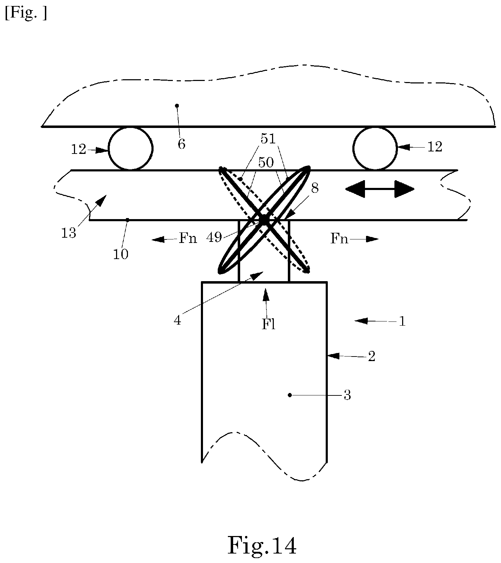

Bei einer Einphasenerregung des Ultraschallaktors 1 durch die Spannung U1 gemäß den Figuren 8 und 9 mit der Frequenz fₐ wird die Form der Bewegungsbahn des Friktionselementes 4 und des Punktes 49 auf seiner Friktionsoberfläche durch den Wert k in den oben genannten Grenzen bestimmt. Dabei kann die in Fig. 14 dargestellte Bewegungsbahn die Form einer geneigten Linie 50 oder die Form einer schmalen Ellipse 51 haben.

Im Ergebnis der akustischen Längsstehwelle bildet sich die Längskraft Fₗ, die die Friktionsoberfläche 8 des Friktionselementes 4 an die Friktionsschicht 10 des anzutreibenden Elements 11 anpresst und drückt. Diese Kraft bestimmt die Reibungskraft zwischen dem Friktionselement 4 und der Friktionsschicht 10 des anzutreibenden Elements 11.

Durch die akustische Biegestehwelle entsteht die Querkraft Fₙ, die das anzutreibende Element 11 in Bewegung versetzt. Diese Kraft entsteht durch das Biegen der piezoelektrischen Platte 3 des Ultraschallaktors 1 über seine Dicke T.

Die Dicke T der piezoelektrischen Platte im erfindungsgemäßen Motor ist bedeutend kleiner als die Höhe der piezoelektrischen Platte bei bisher bekannten Ultraschallmotoren. Das ist durch die Anzahl der in der piezoelektrischen Platte 3 erzeugten akustischen Halbwellen - aufgrund der Ausbildung der ersten Mode der Längsstehwelle und der dritten Mode der Biegestehwelle - bedingt.

Für die Erzeugung einer Biegestehwelle im Ultraschallaktor 1 des erfindungsgemäßen Ultraschallmotors ist eine wesentlich geringere elektrische Energie erforderlich. Daher funktioniert der erfindungsgemäße Ultraschallmotor wesentlich effektiver als beispielsweise die aus den Patentschriften US 5,877,579, US 5,714,833 und US 6,806,620 B1 bekannten Ultraschallmotoren. Der erfindungsgemäße Ultraschallmotor benötigt weniger elektrische Energie, wodurch kleinere mechanische Verluste bei höheren Bewegungsgeschwindigkeiten des anzutreibenden Elements auftreten. Gleichzeitig ermöglicht der Motor höhere Bewegungskräfte.

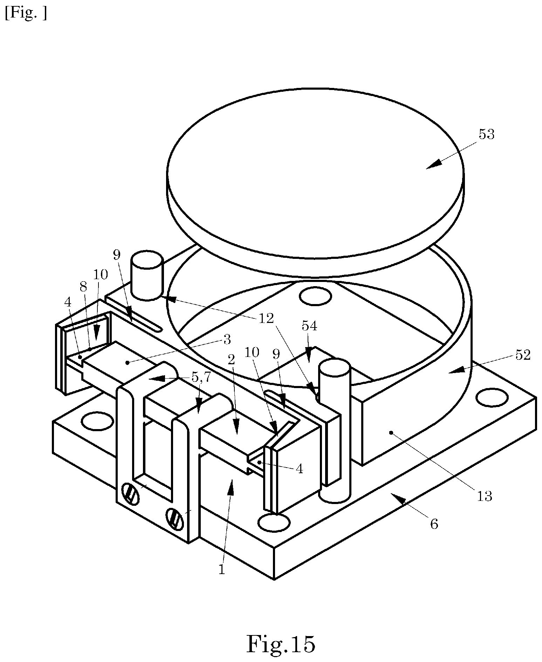

Fig. 15 zeigt eine mögliche Ausführungsform des erfindungsgemäßen Ultraschallmotors als Antrieb einer Linse 53 in einem Mikroobjektiv 52 zur Scharfeinstellung der Abbildung eines optischen Gebers 54.

## Patentansprüche

1. Ultraschallmotor, umfassend einen als Wellenleiter-Resonator (2) fungierenden Ultraschallaktor (1) in Form einer rechteckigen piezoelektrischen Platte (3) mit zwei flächenmäßig größten Flächen als Hauptflächen (19), die sich jeweils mit einer Länge (L) in eine Längsrichtung erstrecken, und die Hauptflächen (19) miteinander verbindenden Seitenflächen (20,21), ein anzutreibendes Element (11) und eine elektrische Erregervorrichtung (31); wobei die Seitenflächen (20,21) zwei lange Seitenflächen (20) und zwei kurze Seitenflächen (21) umfassen, die kurzen Seitenflächen (21) eine Breite (B) in eine Breitenrichtung und eine Dicke (T) in eine Dickenrichtung des Ultraschallaktors (1) bestimmen, und die piezoelektrische Platte (3) entlang ihrer Längsrichtung in drei Teile unterteilt ist, wobei der zentrale Teil einen Generator (22) für eine akustische Längsstehwelle bildet und die an den zentralen Teil angrenzenden peripheren Teile Generatoren (23) für eine akustische Biegestehwelle bilden, und jeder der Generatoren (22, 23) mit der elektrischen Erregervorrichtung (31) verbunden und elektrisch ansteuerbar ist, **dadurch gekennzeichnet, dass** jeder der Generatoren (23) für eine akustische Biegestehwelle entlang der Dickenrichtung der piezoelektrischen Platte (3) in zwei gleichgroße und elektrisch separat ansteuerbare Teilgeneratoren (24, 25) unterteilt ist, und die Teilgeneratoren (24, 25) jeweils Schichten von Erregerelektroden (28) und Schichten von allgemeinen Elektroden (29) und dazwischen angeordnete Schichten von Piezokeramik (30) aufweisen, und an wenigstens einer kurzen Seitenfläche (21) des Ultraschallaktors (1) mindestens ein Friktionselement (4) angeordnet ist, welches mit dem anzutreibenden Element (11) in Friktionskontakt steht.

2. Ultraschallmotor nach Anspruch 1, **dadurch gekennzeichnet, dass** der Generator (22) für die akustische Längsstehwelle Schichten von Erregerelektroden (28) und Schichten von allgemeinen Elektroden (29) und dazwischen angeordneten Schichten von Piezokeramik (30) umfasst.

3. Ultraschallmotor nach Anspruch 1, **dadurch gekennzeichnet, dass** der Generator (22) für die akustische Längsstehstehwelle entlang der Dickenrichtung der piezoelektrischen Platte (3) in zwei gleichgroße und elektrisch separat ansteuerbare Teilgeneratoren (26, 27) geteilt ist, und die Teilgeneratoren (24, 25) Schichten von Erregerelektroden (28), Schichten von allgemeinen Elektroden (29) und dazwischen angeordneten Schichten von Piezokeramik (30) aufweisen.

4. Ultraschallmotor nach einem der vorhergehenden Ansprüche, **dadurch gekennzeichnet, dass** die Schichten von Erregerelektroden (28) und die Schichten allgemeiner Elektroden (29) und die Schichten von jeweils dazwischen angeordneter Piezokeramik (30) parallel zu den Hauptflächen (19) angeordnet sind.

5. Ultraschallmotor nach einem der vorhergehenden Ansprüche, **dadurch gekennzeichnet, dass** das Verhältnis von Länge (L) zu Dicke (T) des Ultraschallaktors (1) zwischen 9 und 11 liegt, so dass im Ultraschallaktor (1) gleichzeitig die erste Mode der akustischen Deformationslängswelle und die dritte Mode der akustischen Deformationsbiegewelle gleicher Frequenz (fₐ) anregbar ist.

6. Ultraschallmotor nach einem der vorhergehenden Ansprüche, **dadurch gekennzeichnet, dass** das Verhältnis von Breite (B) zu Dicke (T) des Ultraschallaktors (1) zwischen 2 und 3 liegt.

7. Ultraschallmotor nach einem der vorhergehenden Ansprüche, **dadurch gekennzeichnet, dass** die in Dickenrichtung der piezoelektrischen Platte (3) des Ultraschallaktors (1) gesehen benachbarten Piezokeramikschichten entgegengesetzt gerichtet polarisiert sind.

8. Ultraschallmotor nach einem der vorhergehenden Ansprüche, **dadurch gekennzeichnet, dass** die elektrische Erregervorrichtung (31) eine elektrische Zweiphasenspannung gleicher Frequenz (fₐ) zur unabhängigen symmetrischen Zweiphasenerregung des Generators (22) für die akustische Längsstehwelle und der Generatoren (23) für die akustische Biegewelle bereitstellt.

9. Ultraschallmotor einem der Ansprüche 1 bis 7, **dadurch gekennzeichnet, dass** die elektrische Erregervorrichtung (31) eine elektrische Einphasenspannung zur gleichzeitigen symmetrischen Erregung des Generators (22) der akustischen Längsstehwelle und zur asymmetrischen Erregung der Generatoren (23) für die akustische Biegestehwelle bereitgestellt.

10. Ultraschallmotor nach einem der Ansprüche 1 bis 7, **dadurch gekennzeichnet, dass** die elektrische Erregervorrichtung (31) eine elektrische Einphasenspannung zur gleichzeitigen asymmetrischen Erregung des Generators (22) der akustischen Längsstehwelle und zur asymmetrischen Erregung der Generatoren (23) für die akustische Biegestehwelle bereitstellt.

## Claims

1. Ultrasonic motor comprising an ultrasonic actuator (1), functioning as a waveguide resonator (2), in the form of a rectangular piezo-electrical plate (3) having two surfaces that are largest in terms of area as main surfaces (19), each extending in a longitudinal direction with a length (L), and side surfaces (20, 21) that join said main surfaces (19) to one another, an element to be driven (11) and an electrical excitation device (31), wherein the side surfaces (20, 21) comprise two long side surfaces (20) and two short side surfaces (21), the short side surfaces (21) define a width (B) in a width direction and a thickness (T) in a thickness direction of the ultrasonic actuator (1), and said piezo-electrical plate (3) is along its longitudinal direction divided into three parts, wherein the central part forms a generator (22) for an acoustic longitudinal standing wave, and the peripheral parts bordering said central part form generators (23) for an acoustic bending standing wave, and each of said generators (22, 23) is electrically connected to said electrical excitation device (31) and can be electrically controlled, **characterized in that** each of said generators (23) for an acoustic bending standing wave is divided, along the thickness direction of said piezo-electrical plate (3) into two equally-sized and electrically individually controllable sub-generators (24, 25), said sub-generators (24, 25) each having layers of excitation electrodes (28), and layers of general electrodes (29), and layers of piezo-ceramics (30) arranged therebetween, and at least one friction element (4) is arranged on at least one short side surface (21) of said ultrasonic actuator (1) and is in frictional contact with said element to be driven (11).

2. Ultrasonic motor according to claim 1, **characterized in that** said generator (22) for said acoustic longitudinal standing wave comprises layers of excitation electrodes (28) and layers of general electrodes (29) and layers of piezo-ceramics (30) arranged therebetween.

3. Ultrasonic motor according to claim 1, **characterized in that** said generator (22) for said acoustic longitudinal standing wave is along the thickness direction of said piezo-electric plate (3) divided into two equally-sized and electrically individually controllable sub-generators (26, 27), and said sub-generators (24, 25) comprise layers of excitation electrodes (28), layers of general electrodes (29) and layers of piezo-ceramics (30) arranged therebetween.

4. Ultrasonic motor according to one of the preceding claims, **characterized in that** said layers of excitation electrodes (28) and said layers of general electrodes (29) and said layers of piezo-ceramics (30) respectively arranged therebetween are arranged parallel to said main surfaces (19).

5. Ultrasonic motor according to one of the preceding claims, **characterized in that** the ratio of the length (L) to the thickness (T) of said ultrasonic actuator (1) is between 9 and 11, so that the first mode of the acoustic deformation longitudinal wave and the third mode of the acoustic deformation bending wave of the same frequency (fₐ) can simultaneously be excited in said ultrasonic actuator (1).

6. Ultrasonic motor according to one of the preceding claims, **characterized in that** the ratio of the width (B) to the thickness (T) of said ultrasonic actuator (1) is between 2 and 3.

7. Ultrasonic motor according to one of the preceding claims, **characterized in that** said piezo-ceramic layers (3), bordering one another when viewed in the thickness direction of said piezo-electric plate of said ultrasonic actuator (1), are polarized in the opposite direction.

8. Ultrasonic motor according to one of the preceding claims, **characterized in that** said electrical excitation device (31) provides electrical two-phase voltage of the same frequency (fₐ) for the independent symmetrical two-phase excitation of said generator (22) for said acoustic longitudinal standing wave and said generators (23) for said acoustic bending wave.

9. Ultrasonic motor according to one of the claims 1 to 7, **characterized in that** said electrical excitation device (31) provides electrical single-phase voltage for the simultaneous symmetrical excitation of said generator (22) for said acoustic longitudinal standing wave and for the asymmetrical excitation of said generators (23) for said acoustic bending standing wave.

10. Ultrasonic motor according to one of the claims 1 to 7, **characterized in that** said electrical excitation device (31) provides electrical single-phase voltage for the simultaneous asymmetrical excitation of said generator (22) of said acoustic longitudinal standing wave and for the asymmetrical excitation of said generators (23) for the acoustic bending standing wave.

## Revendications

1. Moteur ultrasonique, comprenant un actionneur ultrasonique (1) faisant office de résonateur-guide d'ondes (2), et se présentant sous la forme d'une plaque piézoélectrique (3) rectangulaire avec deux faces les plus grandes en surface en tant que faces principales (19), qui s'étendent chacune respectivement avec une longueur (L) dans une direction longitudinale, et avec des faces latérales (20, 21) reliant ensemble les faces principales (19), un élément (11) à entraîner et un dispositif d'excitation électrique (31), moteur ultrasonique
dans lequel les faces latérales (20, 21) comprennent deux faces latérales longues (20) et deux faces latérales courtes (21), les faces latérales courtes (21) déterminant une largeur (B) dans une direction de largeur et une épaisseur (T) dans une direction d'épaisseur de l'actionneur ultrasonique (1), et la plaque piézoélectrique (3) est subdivisée en trois parties le long de sa direction longitudinale, et
dans lequel la partie centrale forme un générateur (22) pour une onde acoustique stationnaire longitudinale, et les parties périphériques adjacentes à la partie centrale forment des générateurs (23) pour une onde acoustique stationnaire de flexion, et chacun des générateurs (22, 23) est relié au dispositif d'excitation électrique (31) et peut être commandé électriquement par celui-ci,
**caractérisé en ce que** chacun des générateurs (23) pour une onde acoustique stationnaire de flexion est subdivisé le long de la direction de l'épaisseur de la plaque piézoélectrique (3), en deux générateurs partiels (24, 25) de même grandeur et pouvant être commandés électriquement de manière séparée, et les générateurs partiels (24, 25) présentent respectivement des couches d'électrodes d'excitation (28) et des couches d'électrodes générales (29) et des couches de piézo-céramique (30) agencées entre elles, et **en ce que** sur au moins une face latérale courte (21) de l'actionneur ultrasonique (1), est agencé au moins un élément de friction (4), qui est en contact de friction avec l'élément (11) à entraîner.

2. Moteur ultrasonique selon la revendication 1, **caractérisé en ce que** le générateur (22) pour l'onde acoustique stationnaire longitudinale comprend des couches d'électrodes d'excitation (28) et des couches d'électrodes générales (29) et des couches de piézo-céramique (30) agencées entre elles.

3. Moteur ultrasonique selon la revendication 1, **caractérisé en ce que** le générateur (22) pour l'onde acoustique stationnaire longitudinale, est divisé le long de la direction de l'épaisseur de la plaque piézoélectrique (3), en deux générateurs partiels (26, 27) de même grandeur et pouvant être commandés électriquement de manière séparée, et les générateurs partiels (24, 25) présentent des couches d'électrodes d'excitation (28), des couches d'électrodes générales (29) et des couches de piézo-céramique (30) agencées entre elles.

4. Moteur ultrasonique selon l'une des revendications précédentes, **caractérisé en ce que** les couches d'électrodes d'excitation (28) et les couches d'électrodes générales (29) et les couches de piézo-céramique (30) agencées respectivement entre elles, sont agencées parallèlement aux faces principales (19).

5. Moteur ultrasonique selon l'une des revendications précédentes, **caractérisé en ce que** le rapport de la longueur (L) à l'épaisseur (T) de l'actionneur ultrasonique (1) se situe entre 9 et 11, de sorte que dans l'actionneur ultrasonique (1) il est possible de produire simultanément l'excitation du premier mode de l'onde acoustique longitudinale de déformation et le troisième mode de l'onde acoustique de déformation de flexion de même fréquence (fₐ).

6. Moteur ultrasonique selon l'une des revendications précédentes, **caractérisé en ce que** le rapport de la largeur (B) à l'épaisseur (T) de l'actionneur ultrasonique (1), se situe entre 2 et 3.

7. Moteur ultrasonique selon l'une des revendications précédentes, **caractérisé en ce que** les couches de piézo-céramique voisines vues dans la direction de l'épaisseur de la plaque piézoélectrique (3) de l'actionneur ultrasonique (1), sont polarisées selon des sens opposés.

8. Moteur ultrasonique selon l'une des revendications précédentes, **caractérisé en ce que** le dispositif d'excitation électrique (31) fournit une tension électrique biphasée de même fréquence (fₐ) pour l'excitation biphasée symétrique indépendante du générateur (22) pour l'onde acoustique stationnaire longitudinale, et des générateurs (23) pour l'onde acoustique de flexion.

9. Moteur ultrasonique selon l'une des revendications 1 à 7, **caractérisé en ce que** le dispositif d'excitation électrique (31) fournit une tension électrique monophasée pour l'excitation simultanée symétrique du générateur (22) de l'onde acoustique stationnaire longitudinale, et l'excitation asymétrique des générateurs (23) pour l'onde acoustique stationnaire de flexion.

10. Moteur ultrasonique selon l'une des revendications 1 à 7, **caractérisé en ce que** le dispositif d'excitation électrique (31) fournit une tension électrique monophasée pour l'excitation simultanée asymétrique du générateur (22) de l'onde acoustique stationnaire longitudinale, et l'excitation asymétrique des générateurs (23) pour l'onde acoustique stationnaire de flexion.
